**Europäisches Patentamt**

**European Patent Office**

**Office européen des brevets**

(19)

(11) Veröffentlichungsnummer: **0 368 143**

**A2**

(12) # EUROPÄISCHE PATENTANMELDUNG

(21) Anmeldenummer: **89120280.6**

(51) Int. Cl.5: **H01L 23/15, F02P 5/145**

(22) Anmeldetag: **02.11.89**

(30) Priorität: **09.11.88 DE 3837975**

(43) Veröffentlichungstag der Anmeldung:
**16.05.90 Patentblatt 90/20**

(84) Benannte Vertragsstaaten:
**DE FR GB IT**

(71) Anmelder: **TELEFUNKEN electronic GmbH**
**Theresienstrasse 2**
**D-7100 Heilbronn(DE)**

(72) Erfinder: **Kilian, Hermann**
**An der Strut 3**
**D-8531 Diespeck(DE)**
Erfinder: **Leicht, Günter**
**Neukreuthstrasse 11**
**D-8602 Stegaurach(DE)**
Erfinder: **Niemetz, Linhard**
**Schwabacher Strasse 41b**
**D-8540 Rednitzhembach(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

(54) **Elektronisches Steuergerät.**

(57) Beim Anmeldungsgegenstand handelt es sich um ein elektronisches Steuergerät mit Ansteuerungs- und Leistungs-Bauelementen, insbesondere Zündsteuergerät, dessen elektronische Schaltung aus verschiedenen Baugruppen in Hybridtechnik besteht. Um den Montageaufwand und die Herstellungskosten zu reduzieren, sowie das Bauvolumen zu verringern, ist nach der Erfindung vorgesehen, daß die Baugruppen der elektronischen Schaltung in einer Hybridschaltung integriert und auf einem einzigen gemeinsamen Trägerkörper angeordnet sind. Der Trägerkörper ist dabei als elektrisch nicht leitfähiger Keramiktrager aus $Al_2O_3$ ausgebildet, durch den die elektronische Schaltung des Steuergeräts von einem Kühlkörper elektrisch isoliert angebracht ist.

FIG.1

## Elektronisches Steuergerät

Die Erfindung betrifft ein elektronisches Steuergerät nach dem Oberbegriff des Anspruchs 1.

Die elektronischen Schaltungen derartiger Steuergeräte, beispielsweise von Zündsteuergeräten, wie sie insbesondere bei Transistorzündungen eingesetzt werden, bestehen aus verschiedenen Baugruppen, die als Hybridschaltungen auf jeweils einem Trägerkörper aufgebracht werden. Meistens werden als Baugruppen der elektronischen Schaltung dabei ein Steuerteil, ein Schaltelement sowie eine RC-Kombination benötigt.

Das Steuerteil dient zur Ansteuerung und Regelung des Schaltelements und besteht aus einem mit Leiterbahnen und Widerständen bedruckten Keramiksubstrat, auf das Bauelemente in SMD- und in Chip-Form aufgebracht sind. Das Schaltelement stellt den Leistungsschalter dar, der bei Zündsteuergeräten den Zündspulenstrom ein- bzw. ausschaltet. Es besteht beispielsweise aus einem Leistungstransistor-Chip, der auf einem metallischen Wärmespreizer aufgelötet ist, der zur Verbesserung der Wärmeabführung dient. Die RC-Kombination enthält einen Keramik-Hochspannungskondensator und einen Leistungswiderstand. Bei Zündsteuergeräten werden diese Bauteile entweder diskret in einen Kunststoffrahmen des Gehäuses eingebaut oder ein separates Keramiksubstrat, das einen gedruckten Leistungswiderstand enthält, wird mit einem Hochspannungskondensator bestückt.

Das Steuerteil der elektronischen Schaltung ist mit einer mittleren, das Schaltelement mit einer hohen Verlustleistung behaftet; diese verlustleistung muß mittels eines Kühlkörpers abgeführt werden.

Zur elektrischen Isolation vom Kühlkörper werden die Schaltungskomponenten der elektronischen Schaltung jeweils getrennt auf einen metallisierten Keramikträger aufgebracht, einzeln auf dem Kühlkörper montiert und elektrisch miteinander verbunden.

Aus der DE-PS 36 04 074 ist ein Zündsteuergerät bekannt, dessen Schaltungskomponenten auf einer AIN-Trägerkeramik aufgebracht werden. Jedoch ist das AIN-Trägerkeramikmaterial sehr teuer. Außerdem fehlt der mechanisch stabilisierende Kühlkörper, so daß das System bei der Montage in das Kraftfahrzeug bruchanfällig ist.

- Der Erfindung liegt die Aufgabe zugrunde, den Montageaufwand und die Kosten bei der Herstellung von elektronischen Steuergeräten, insbesondere von Zündsteuergeräten zu reduzieren und gleichzeitig das Bauvolumen zu verringern.

Dies wird erfindungsgemäß dadurch erreicht, daß die Baugruppen der elektronischen Schaltung in einer Hybridschaltung integriert und auf einem einzigen gemeinsamen Trägerkörper angeordnet sind.

Vorteilhafte Ausgestaltungen der Erfindung ergeben sich aus den Unteransprüchen.

Die elektrische Verbindung zwischen den einzelnen Baugruppen bzw. Komponenten der elektronischen Schaltung wird also bereits bei der Erstellung der Schichtschaltung realisiert, so daß die zusätzliche Verdrahtung und ein Montageabstand zwischen den einzelnen Schaltungskomponenten nicht benötigt wird. Damit kann aber eine höhere Packungsdichte der Bauteile, verbunden mit einem geringeren Platzbedarf realisiert werden.

Anstelle der Prüfung der einzelnen Komponenten kann ein gemeinsamer Funktionsabgleich bzw. eine gemeinsame Funktionsprüfung aller Schaltungskomponenten bei der fertigen Schaltung vorgenommen werden.

Da die Zwischenverbindungen entfallen und nur ein Gesamtteil auf den Kühlkörper montiert werden muß, ist auch eine kostengünstige Endmontage möglich.

Vorteilhaft wird ein kostengünstiger $Al_2O_3$-Keramikträger anstelle einer teueren und dicken AIN-Trägerkeramik eingesetzt. Bei der Montage dieser dünnen Isolierkeramik auf einem mechanisch stabilen Aluminium-Kühlkorper besteht keine Gefahr, daß das Steuergerät bei der Endmontage beschädigt wird.

Der Aufbau und die Herstellung eines elektronischen Steuergeräts nach der Erfindung soll nun anhand eines Zündsteuergeräts beschrieben werden.

Es zeigen:

Figur 1 in Draufsicht den Aufbau eines Zündsteuergeräts.

Figur 2 das Zündsteuergerät im Schnitt gemäß der Linie A-A in Figur 1.

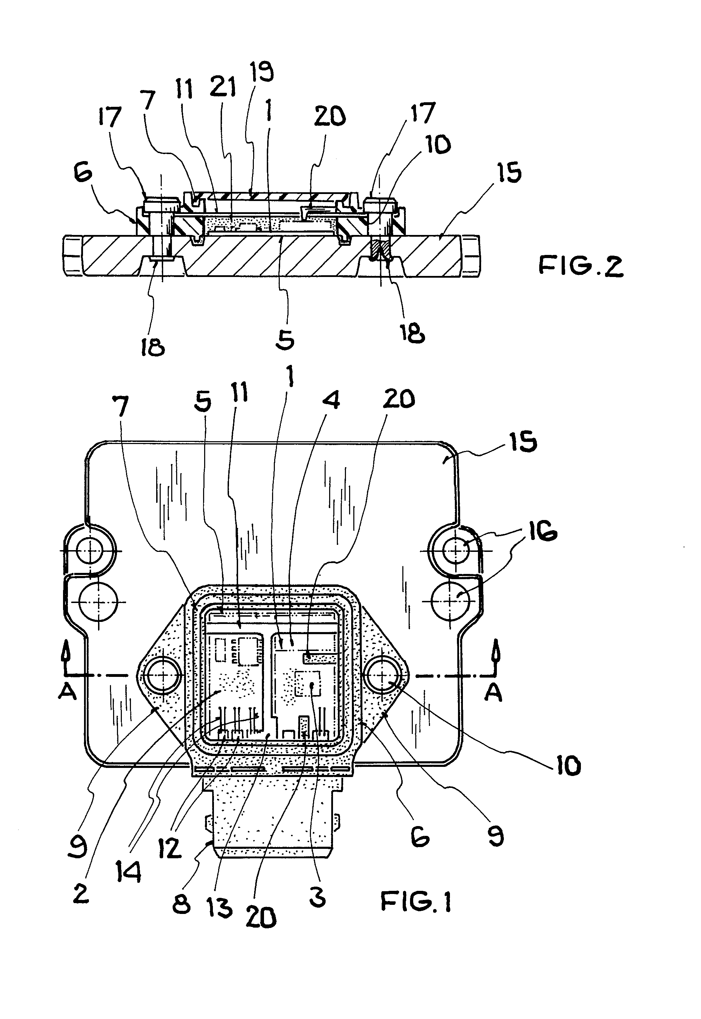

Gemäß Figur 1 und 2 enthält das Zündsteuergerät einen Kühlkörper 15, einen Gehäusekörper 6 mit Kunststoffrahmen 7, Steckeranschlußbuchse 8 und Deckel 19 sowie eine elektronische Zündschaltung 1.

Alle Baugruppen der elektronischen Zündschaltung 1, das Steuerteil 2, das Leistungsteil 3 und die RC-Kombination 4, sind gemeinsam auf dem keramischen Trägerkörper 5 aufgebracht, der zur elektrischen Isolierung der elektronischen Schaltung 1 vom Kühlkörper 15 dient.

Im Kunststoff-Gehäusekörper 6 ist eine Metallplatine 11 integriert, deren Steckeranschlüsse 12, 13 über Bonddrähte 14 mit der elektronischen Schaltung 1 verbunden sind. Die Metallplatine 11 dient somit zur Kontaktierung der elektronischen Schaltung 1 und stellt eine externe Anschlußmöglichkeit des Zündsteuergeräts über die Steckeranschlußbuchse 8 her.

Die Löcher 10 im flanschförmigen Teil 9 des Kunststoffrahmens 7 werden bei der Befestigung des Rahmens 7 auf dem Kühlkörper 15 verwendet. Die Löcher 16 im Kühlkörper dienen zur Montage des Zündsteuergeräts auf einem Blech im Motorraum des Kraftfahrzeugs.

Über die im Gehäuserahmen 7 integrierten Andrückelemente 20 wird die elektronische Schaltung 1 während der Montage definiert gegen den Kühlkörper 15 gepreßt.

Im folgenden soll das Herstellungs- bzw. Mon-tageverfahren des Zündsteuergeräts erläutert wer-den.

Die Schaltungsplatine zur Aufnahme der elektronischen Bauelemente der Zundschaltung besteht aus einem keramischen Trägerkörper 5, vorzugsweise aus $Al_2O_3$, der mit Leiterbahnen und Widerstanden in Dickschichttechnik bedruckt ist. Bauelemente in SMD- und Chip-Form, beispielsweise ICs und Kondensatoren, und der bereits auf einem Wärmespreizer gelötete Transistor-Chip werden auf die mit Lotpaste versehenen Leiterbahnen bestückt und in einem gemeinsamen Lötvorgang sowohl mit der Schaltungsplatine als auch untereinander verbunden.

Anschließend werden die Anschlüsse der übrigen Halbleiterbauelemente mittels Bonddrähten auf den Leitbahnen des Keramikträgerkörpers 5 kontaktiert. Die Hybridschaltung 1 ist nun elektrisch funktionsfähig, so daß ein notwendiger Funktionsabgleich bzw. eine Funktionsprüfung an der bereits kompletten elektronischen Schaltung durchgeführt werden kann.

Zur Bildung des Gehäusekörpers 6 mit Rahmen 7 und Stekeranschlußbuchse 8 wird eine Metallplati-ne 11 mit Kunststoff umspritzt. Die Metallplatine 11 erstreckt sich bis in die Steckeranschlußbuchse 8 und bildet somit die Kontaktanschlüsse für einen externen Steckeranschluß des Zündsteuergeräts.

Die Hybridschaltung 1 wird nun auf einen mit Kleber beschichteten Kühlkörper 15 gesetzt und mittels des Gehäuserahmens 7, welcher auf dem Kühlkörper 15 mit Hilfe der Nieten 17 befestigt wird, während der Kleberaushärtung definiert gegen den Kühlkörper 15 gepreßt. Dies erfolgt über die im Gehäuserahmen integrierten, verformbaren Andrückelemente 20, welche auf den Wärmespreizer des Transistor-Chips drücken. Diese Maßnahme erzeugt die erforderliche dünne, porenfreie Kleberschicht zwischen Trägerkeramik 5 und Kühlkörper 15, welche für eine gute Wärmeableitung von der Trägerkeramik zum Kühlkörper erforderlich ist.

Bei der Endmontage werden die Gehäuseanschlüsse 12, 13 mittels Bonddrähten 14 mit den Anschlüssen auf der elektronischen Schaltung 1 verbunden, die Schaltung mittels Weichverguß 21 verkapselt und der Gehäuserahmen 7 mit einem Deckel 19 verschlossen.

Das Zündsteuergerät ist nun für den Einbau ins Kraftfahrzeug tauglich; die Montage erfolgt auf einem Blech im Motorraum mittels der Löcher 16 im Kühlkörper.

Die Integration verschiedener Baugruppen auf einem einzigen gemeinsamen Trägerkörper läßt sich nicht nur bei Zündsteuergeräten, sondern bei allen Steuergeräten mit Ansteuerungs- und Leistungs-Bauelementen einsetzen, die verschiedene Baugruppen in Hybridtechnik besitzen.

## Ansprüche

1) Elektronisches Steuergerät mit Ansteuerungs- und Leistungs-Bauelementen, insbe-sondere Zündsteuergerät, dessen elektronische Schaltung (1) aus verschiedenen Baugruppen (2, 3, 4) in Hybridtechnik besteht, dadurch gekennzeichnet, daß die Baugruppen (2, 3, 4) der elektronischen Schaltung (1) in einer Hybridschaltung integriert und auf einem einzigen gemeinsamen Trägerkörper (5) angeordnet sind.

2) Elektronisches Steuergerät nach Anspruch 1, dadurch gekennzeichnet, daß der Trägerkörper (5) als elektrisch nicht leitfähiger Keramikträger aus $Al_2O_3$ ausgebildet ist.

3) Elektronisches Steuergerät nach Anspruch 1 und 2, dadurch gekennzeichnet, daß die elektronische Schaltung (1) auf einem Kühlkörper (15) angebracht ist.

4) Zündsteuergerät nach Anspruch 1 bis 3, dadurch gekennzeichnet, daß die elektronische Zündschaltung (1) als Baugruppen ein Steuerteil (2), ein Schaltelement (3) und eine RC-Kombination (4) enthält, die auf einem mit Leitbahnen und Widerständen bedruckten gemeinsamen Trägerkörper (5) angeordnet sind.

HN 88/41

FIG. 2

FIG. 1